Europäisches Patentamt

European Patent Office

Office européen des brevets

(11) EP 1 126 562 A1

(19)

(12) **EUROPÄISCHE PATENTANMELDUNG**

(43) Veröffentlichungstag:
22.08.2001 Patentblatt 2001/34

(51) Int Cl.⁷: **H01R 13/66**, H01R 24/04,
H01R 13/719

(21) Anmeldenummer: 00811196.5

(22) Anmeldetag: 15.12.2000

(84) Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(30) Priorität: **22.12.1999 EP 99811190**

(71) Anmelder: **Frech, Fridolin Alois**
**CH-8488 Turbenthal (CH)**

(72) Erfinder: **Frech, Fridolin Alois**
**CH-8488 Turbenthal (CH)**

(74) Vertreter: **Patentanwälte Breiter + Wiedmer AG**
**Seuzachstrasse 2**
**Postfach 366**
**8413 Neftenbach/Zürich (CH)**

(54) **Leiterführungsplatte**

(57)     Die Leiterführungsplatte (10) aus elektrisch isolierendem Material für die Einzelleiter (24) eines symmetrischen Kabels wird in einem mehrpoligen Stecker, insbesondere in einem HF-Stecker, eingesetzt. Die integrierte oder eingeschobene Leiterführungsplatte (10) weist in die Bohrungen (22) für die Einzelleiter (24) mündende Kontaktschlitze (18) für die Führung elektrischer Steckerkontakte (28) auf. In den Kontaktschlitzen (18) und um die Kontaktschlitze (18) herum hat die Leiterführungsplatte (10) ein elektrisch leitendes Kontaktauge (20), welches beim Anpressen der Steckerkontakte (28) gleichzeitig mit den Einzelleitern (24) im Bereich der Leiterführungsplatte (10) angeordnete Kondensatoren zur Kompensation von Störeffekten anschliesst. Das Kontaktauge (20) ist direkt auf die Leiterführungsplatte (10) aufgebracht oder in Folienform eingelegt.

Fig. 4

**Beschreibung**

Die Erfindung bezieht sich auf eine Leiterführungsplatte aus elektrisch isolierendem Material für die Einzelleiter eines symmetrischen Kabels in einem mehrpoligen Stecker, insbesondere in einem HF-Stecker für symmetrische Kabel, welche integrierte oder eingeschobene Leiterführungsplatte in die Bohrungen für die Einzelleiter mündende Kontaktschlitze für die Führung elektrischer Steckerkontakte aufweist.

Es sind verschiedene Fabrikate von FCC-Steckern für symmetrische Kabel auf dem Markt, beispielsweise mit 4,6,8,10,12,14 oder mehr Anschlüssen, wie die elektrischen Kontakte auch genannt werden. Sie werden insbesondere für elektrische Anschlüsse an Kommunikationshaupt- und Peripheriegeräte eingesetzt, beispielsweise ISDN, Telefon, Terminal und Modem, sowie PC, Host oder Datennetzwerksysteme.

An Stecker angeschlossene handelsübliche symmetrische Kabel bekannter Bauart bestehen in der Regel aus in eine flexible Masse eingebetteten Kupferdrähten oder -litzen, sowie anwendungsbezogen einem peripheren Schirm und einem äusseren Isolationsmantel. Der Schirm umfasst wenigstens ein Geflecht, Gewebe oder Gestrick aus Kupferdrähten, welchem innenseitig eine Aluminiumfolie anliegen kann. Die Aluminiumfolie dient auch als Feuchtigkeitssperre.

Es sind Stecker für Steckverbindersysteme von symmetrischen Kabeln auf dem Markt, welche ein metallisches Steckergehäuse haben. Diese sind mit einem mechanisch stützenden Kunststoffeinsatz ausgekleidet, wobei eine einschiebbare Leiterführungsplatte einen Teil der Auskleidung bilden kann. Ein mehrpoliger Stecker mit einer vorteilhaften Leiterführungsplatte ist in der EP, A1 0932225 offenbart.

In der heute üblichen HF-Uebertragungstechnik mit symmetrischen Kabeln werden Frequenzen bis etwa 600 MHz erreicht. Für derart extreme Arbeitsbedingungen werden in den symmetrischen Kabeln die Einzeladern, mit anderen Worten isolierte Kupferdrähte oder -litzen, paarweise miteinander verdrillt. Bei paarweise verdrillten Einzeladern heben sich die Störsignale weitgehend auf, was gegenüber parallel geführten Einzeladern eine wesentliche Verbesserung darstellt.

Die Kontakte dieser Stecker sind in der Regel auf einer Ebene nebeneinander angeordnet. Die verdrillten Einzeladern bzw. Leiter müssen also geöffnet, gerichtet und linear angeordnet werden. Da die Aussenmasse von Steckern für alle Steckverbindersysteme kompatibel sein müssen, sind deren Aussenmasse im voraus festgelegt. In bekannten mehrpoligen Steckern für symmetrische Kabel wird die Verdrillung der Leiter durch die Steckerkonstruktion aufgehoben. Bei einer gezwungenermassen notwendigen Parallelführung der einzelnen Leiter geht durch Wechselwirkung der Parallelführung verglichen mit der paarweise verdrillten Einzelleiterführung Signalqualität verloren.

Bei HF-tauglichen Steckverbindersystemen kann die Störungsunterdrückung bei Frequenzen bis etwa 100 MHz verhältnismässig problemlos mit üblichen, meist nur in der Steckdosenseite angewendeten Massnahmen erfolgen. Im Frequenzbereich über 100 MHz werden die konventionellen Massnahmen je aufwendiger, desto höher die Frequenz ist, und versagen schliesslich ganz.

Der Erfinder hat sich die Aufgabe gestellt, eine Leiterführungsplatte der eingangs genannten Art zu schaffen, welche durch die spezielle Konstruktion im Steckerteil wirksam wird, und auch in Frequenzbereichen bis etwa 600 MHz und mehr eine einfache und wirkungsvolle Kompensation von Störeffekten gewährleistet.

Die Aufgabe wird erfindungsgemäss dadurch gelöst, dass die Leiterführungsplatte in den Kontaktschlitzen und um die Kontaktschlitze herum ein elektrisch leitendes Kontaktauge aufweist, welches beim Anpressen der Steckerkontakte gleichzeitig mit den Einzelleitern im Bereich der Leiterführungsplatte angeordnete Kondensatoren zur Kompensation von Störeffekten anschliesst, wobei das Kontaktauge direkt auf die Leiterführungsplatte aufgebracht oder in Folienform eingelegt ist. Vorteilhafte und weiterbildende Ausführungsformen der Erfindung sind Gegenstand von abhängigen Ansprüchen.

Es ist von erfindungswesentlicher Bedeutung, dass beim Anpressen der Steckerkontakte nicht nur der Anschluss der Steckerkontakte an die elektrischen Leiter des symmetrischen Kabels erfolgt, sondern dass gleichzeitigim gleichen Arbeitsgang des Anpressens - Kondensatoren zur Kompensation von Störeffekten angeschlossen werden. In der Praxis sind dies vorzugsweise Flächenkondensatoren, welche nicht nur bezüglich der Raumausnützung optimal sind, sondern auch eine hohe Kapazität erlauben:

$$C = \varepsilon o \cdot \varepsilon \cdot \frac{F}{d}$$

Wobei gilt:

C = Kapazität

$\varepsilon_0$ = Konstante

$\varepsilon$ = Dielektrizitätskonstante, welche angibt, wieviel mal kleiner die Feldstärke in einem von diesem Stoff erfüllten Raum ist als im Vakuum bei gleicher Erregung

F = Oberfläche der parallelen elektrisch leitenden Materialien

d = Abstand der parallelen elektrisch leitenden Materialien.

Dieser Formel kann entnommen werden, dass eine grosse Kompensationswirkung erreicht wird, wenn die Dielektrizitätskonstante ε und die Oberfläche F möglichst gross, der Abstand d dagegen möglichst klein ist.

Zweckmässig weisen alle Kontaktschlitze eine elektrische Leiterbahn auf, einzelne Kontaktschlitze können jedoch bei Bedarf auch ohne diese Leiterbahn ausgebildet sein.

Die Leiterführungsplatte an sich besteht vorzugsweise aus elektrisch isolierendem Kunststoff und kann in jeder der zahlreichen bekannten Ausführungsformen verwendet werden. Vorzugsweise umfasst sie jedoch zwei parallel versetzte Schenkel mit einem Verbindungssteg, ist also doppelt abgewinkelt oder abgerundet. Dadurch nimmt die Leiterführungsplatte im Längsschnitt im wesentlichen eine Z-förmige Gestalt an. Diesbezüglich wird auf die EP,A1 0932225 verwiesen. Die Kontaktaugen der Leiterführungsplatte sind bevorzugt paarweise mit Flächenkondensatoren verbunden, wobei mit möglichst geringem Aufwand und auf einfache Weise eine möglichst grosse Kondensatorwirkung zu erzielen angestrebt wird. Die Verbindung kann auch über Leiterbahnen erfolgen, welche Bestandteil der Flächenkondensatoren sind.

Nach einer ersten Variante sind die Flächenkondensatoren auf ein- und derselben Ebene bzw. einer Fläche angeordnet, welche auch abgewinkelt oder gekrümmt ausgebildet sein kann. Dabei verlaufen die Flächenkondensatoren jeweils von zwei Steckerkontakten paarweise in kleinem Abstand d aneinander liegend. Die im Abstand d verlaufenden Flächenkondensatoren haben möglichst lange Grenz- oder Seitenflächen, damit sie eine möglichst grosse kapazitive Kopplung aufweisen. Sie greifen beispielsweise finger- oder fächerförmig ineinander, wobei auch feinere Verästelungen ausgebildet werden können. Das fingerförmige Ineinandergreifen kann auch in Rechteckform erfolgen. Schliesslich können die Flächenkondensatoren schlangenförmig nebeneinander liegend auf derselben Ebene verlaufen.

Nach allen Ausführungsformen dieser ersten Variante können die Flächenkondensatoren direkt auf der Leiterführungsplatte, bei im wesentlichen Z-förmiger Leiterführungsplatte vorzugsweise auf dem Verbindungssteg, undloder auf einer wenigstens im Kontaktbereich an der Leiterführungsplatte angebrachten Kunststofffolie ausgebildet sein.

Nach einer zweiten bevorzugten Variante sind die Flächenkondensatoren beidseits eines an der Leiterführungsplatte angebrachten, folienförmigen Dielektrikums ausgebildet. Bezüglich der Kapazität ist dies verglichen mit der Anordnung von seitlich nebeneinanderliegenden Flächenkondensatoren die wesentlich effizientere Ausbildungsform, d. h. die Flächenkondensatoren sind nicht mit ihren Schmalseiten, sondern vollflächig im Abstand d neben- bzw. übereinander angeordnet. Dagegen ist es nach dieser Variante wenig effizient, die Flächenkondensatoren direkt auf der Leiterführungsplatte aufzubringen.

Bei zwei oder paarweise angeordneten elektrischen Steckerkontakten besteht die einfachste Lösung darin, eine Folie beidseits vollflächig mit einem elektrisch leitenden Material zu beschichten und jede Seite in der Kontaktzone eines Kontaktschlitzes zu verbinden. Bei mehreren Leiterpaaren müssen entsprechend viele beidseitig beschichtete Folien an der Leiterführungsplatte angebracht werden.

Statt die Anzahl von Folien zu erhöhen, wird vorzugsweise die elektrisch leitende Schicht in Form von schmalen Streifen herausgeätzt, beispielsweise in langrechteckiger Form.

Falls mehrere beidseits elektrisch leitend beschichtete Dielektrika an derselben Leiterführungsplatte angebracht werden, müssen sie mit einer isolierenden Schutzschicht getrennt werden. Diese Schutzschicht kann entweder eingelegt oder als weitere Schicht aufgebracht werden.

Die Flächenkondensatoren bestehen aus einem leitenden Material, insbesondere Kupfer oder Aluminium, aber auch aus Silber, und/oder einem metallpulverhaltigen Lack. Die Schichten werden mit üblichen Verfahrenstechniken aufgebracht, Metallschichten beispielsweise durch elektrolytische Verfahren, Abscheiden aus der Gasphase oder Aufdampfen. Die metallhaltigen Lackschichten werden beispielsweise durch Siebdruck oder Tampondruck aufgebracht. Selbstverständlich kann statt eines Lacks ein beliebiger Kunststoff mit entsprechender Haftfestigkeit aufgebracht werden.

Der wesentliche Vorteil der direkt oder indirekt mit Flächenkondensatoren bestückten Leiterplatte besteht darin, dass der elektrische Kontakt zu den zu Kompensationszwecken eingesetzten Flächenkondensatoren gleichzeitig und zwangsläufig mit dem Aufbringen des Steckerkontaktes auf das symmetrische Kabel erfolgt. Mit anderen Worten werden im Steckverbindersystem mit einer erfindungsgemässen Leiterführungsplatte nicht nur die Leiter des Kabels mit den Steckerkontakten verbunden, sondern gleichzeitig die Verbindung zu den Störungseffekte unterdrückenden Kompensatoren hergestellt.

Die Erfindung wird anhand von in der Zeichnung dargestellten Ausführungsbeispielen, welche auch Gegenstand von abhängigen Ansprüchen sind, näher erläutert. Es zeigen schematisch:

- Fig. 1 eine Leiterführungsplatte mit direkt aufgebrachten Flächenkondensatoren,
- Fig. 2 ein Detail der Leiterführungsplatte gem. Fig. 1 mit angepressten elektrischen Steckerkontakten.
- Fig. 3 einen Querschnitt durch einen angepressten elektrischen Steckerkontakt,
- Fig. 4 eine Variante gemäss Fig. 2,
- Fig. 5 eine Leiterführungsplatte mit zwei angebrachten Folien,
- Fig. 6 eine Draufsicht auf ein folienförmiges Dielektrikum mit langrechteckigen Flächenkondensatoren,

- Fig. 7 einen Schnitt VI - VI durch die Folie gemäss Fig. 5, und
- Fig. 8 eine perspektivische Teilansicht des Kontaktbereichs einer Leiterführungsplatte.

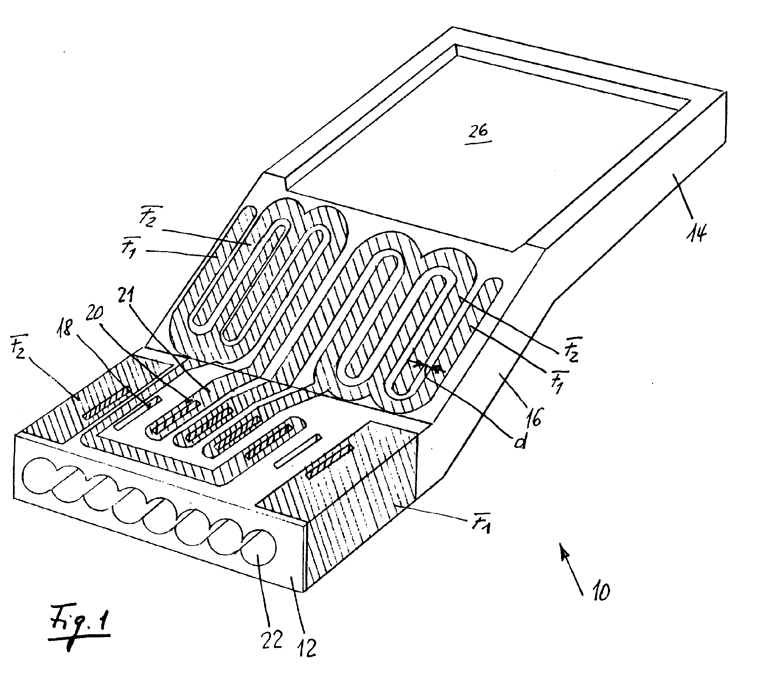

Eine Leiterführungsplatte 10 aus Kunststoff gemäss Fig. 1 ist im wesentlichen Z-förmig ausgebildet, sie umfasst einen Schenkel 12 mit elektrischen Kontaktschlitzen 18, einen Schenkel 14 ohne solche Kontaktschlitze und einen Verbindungssteg 16

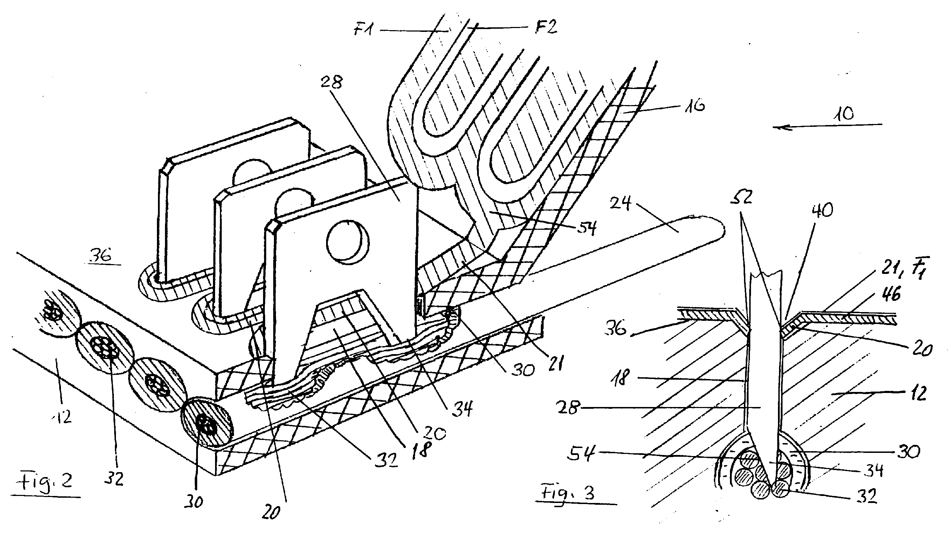

Die Kontaktschlitze 18 sind, wie aus Fig. 2 bis 4 näher ersichtlich, mehrheitlich mit je einem Kontaktauge 20 bedeckt, welches, aufgebracht oder durch den angesteckten elektrischen Steckerkontakt (28 in Fig. 2,3) hinuntergedrückt, bis in die Kontaktschlitze 18 hinunter reichen kann. Im Bereich des Verbindungsstegs 16 gehen diese Kontaktaugen 20, allenfalls über Leiterbahnen 21, in Flächenkondensatoren $F_1$ und $F_2$ über, welche vorliegend fingerförmig ineinander greifen. Diese Flächenkondensatoren $F_1$, $F_2$ sind in einem Abstand d von 0,1 bis 0,5 mm direkt auf den Verbindungssteg 16 aufgebracht. Die Schichtdicke liegt zweckmässig bei wenigen Mikrometern, beispielsweise 10 bis 20 μm. Es können jedoch auch Flächenkondensatoren $F_1$, $F_2$ mit wesentlich grösserer Schichtdicke aufgetragen werden, beispielsweise von wenigen Zehn-tel Millimetern. Für die Kapazität sind jedoch nicht die Flächen $F_1$ und $F_2$ massgebend, sondern deren Dicke und deren Abstand d.

Die beiden äussersten Kontaktschlitze 18, welche als Kontaktführungen dienen, haben den Schenkel 12 der Leiterführungsplatte 10 umgreifende Flächenkondensatoren $F_1$, $F_2$, welche unterhalb des Schenkels 12 in einem Abstand d koppeln. Die zweitäussersten Kontaktschlitze 18 haben keine Kontaktzone.

Im Schenkel 12 der Leiterführungsplatte 10 sind acht mit den Kontaktschlitzen 18 korrespondierende Bohrungen 22 für die anzuschliessenden Einzelleiter 24 (Fig. 2) eines symmetrischen Kabels ausgespart. Die Einführung der Einzelleiter ist in der EP,A1 0932225 beschrieben.

Der Schenkel 14 hat oben und unten je eine wannenförmige Aussparung 26, in welcher zusätzliche Flächenkondensatoren $F_1$, $F_2$ angebracht oder eingelegt werden.

In Fig. 2 ist eine in Längsrichtung aufgeschnittene Leiterführungsplatte 10 dargestellt, mit in die Bohrungen 22 (Fig. 1) eingeführten Einzelleitern 24 mit Litzen 32. Die Isolationsschicht 30 der äussersten Einzelader 24 ist entfernt, die Litzen 32 sind sichtbar.

Die beiden Schneidekanten 34 des elektrischen Steckerkontaktes 28 werden durch die Kontaktaugen 20 und die Kontaktschlitze 18 in die Litzen 32 gedrückt. So kann der elektrische Steckerkontakt 28 die Verbindung zwischen einem Einzelleiter 24 und den auf die Leiterführungsplatte 10 aufgebrachten Kompensationsflächen $F_1$, $F_2$ (Kondensatorflächen) in einem Arbeitsgang herstellen.

Die Leiterbahn 21 des Führungsschlitzes 18 erstreckt sich von Kontaktstellen 52 in diesem Schlitz über dessen eine Einführungsrinne 40 bildende Anschrägung auf die Deckfläche 36 des Schenkels 12 und bildet dort ein umlaufendes Kontaktauge 20.

Beim Aufsetzen und Eindrücken des elektrischen Steckerkontaktes 28 in die Litzen 32 wird dieser wegen der Schneidekante 34 seitlich ausgelenkt und an die Kontaktstellen 52 gedrückt (Fig. 3). Damit entstehen nicht nur mit den Litzen 32 sehr gute elektrische Kontaktstellen 54, sondern auch mit der zu den Flächenkondensatoren $F_1$ und $F_2$ führenden Verbindungen. Dies hat eine automatische und zwangsläufige Kompensation von Störeffekten zur Folge, wenn die Steckerkontakte 28 in ihren einfachheitshalber nicht dargestellten Steckern angepresst werden.

Fig. 3 verdeutlicht den anhand von Fig. 2 beschriebenen und gezeigten Sachverhalt. Der elektrische Steckerkontakt 28 eines Steckers wird zur Herstellung eines elektrischen Steckerkontaktes in einen Kontaktschlitz 18 eingeführt und angepresst, bis dessen Schneidekante 34 die Leiterisolation 30 eines Einzelleiters 24 durchschnitten hat und unter Bildung eines elektrischen Kontaktes 54 auf mehrere Litzen 32 drückt. Gleichzeitig erfolgt über die Kontaktstellen 52, das Kontaktauge 20 und die Leiterbahnen 21 der erfindungswesentliche Kontakt zu den Flächenkondensatoren $F_1$, $F_2$. Das Kontaktauge 20 und die Leiterbahn 21 bzw. $F_1$ sind auf einem elektrisch isolierenden Dielektrikum 46 aufgebracht, welches auf dem Schenkel 12 aufliegt und durch die aufgesetzten elektrischen Kontakte 28 fixiert wird.

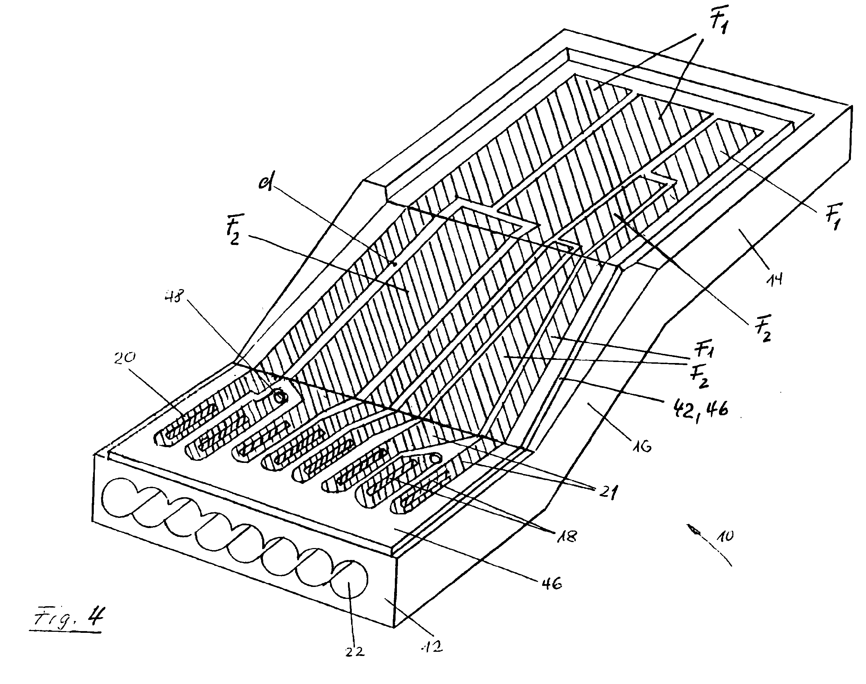

In Fig. 4, einer Variante von Fig, 1, erstrecken sich die Flächenkondensatoren $F_1$, $F_2$ über den Verbindungssteg 16 und den Schenkel 14 ohne elektrische Kontakte. Die Flächenkondensatoren $F_1$, $F_2$ sind auf einer isolierenden Folie 42 oder einem folienförmigen Dielektrikum 46 aufgebracht, welche Folie ihrerseits mit der Leiterführungsplatte 10 verklebt ist oder nur im Kontaktbereich befestigt frei aufliegt. Aus Fig. 4 ist auch erkennbar, dass die Leiterbahnen 21 ein Teil der Flächenkondensatoren $F_1$, $F_2$ sind, eine Kompensation findet bereits im Bereich der Leiterbahnen 21 statt.

Die Durchkontaktierungen 48 erlauben den elektrischen Kontakt zu beidseits des Dielektrikums 46 angeordneten Flächenkondensatoren $F_1$, $F_2$.

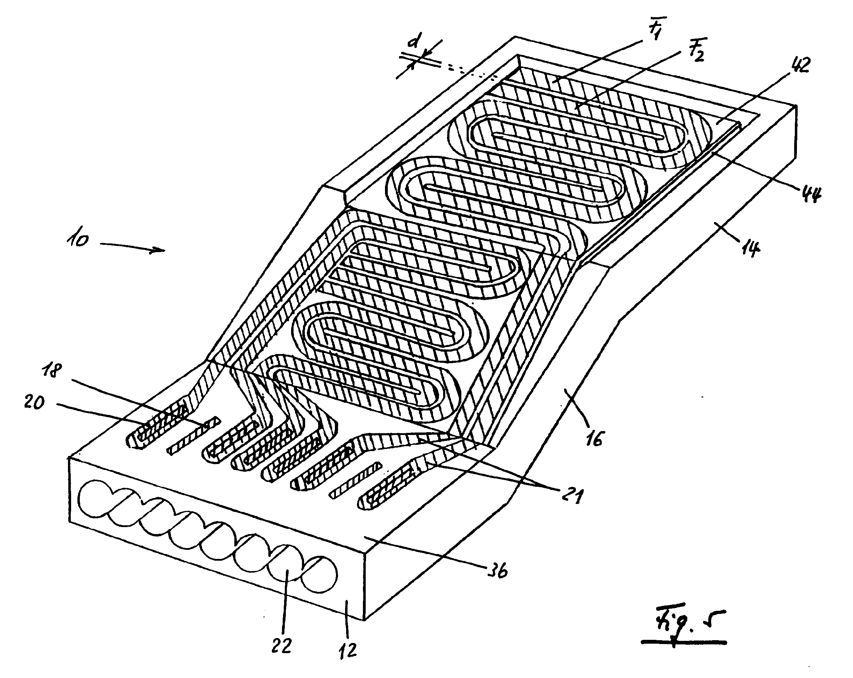

Bezüglich ihrer Grundkonstruktion entspricht die Leiterführungsplatte 10 gemäss Fig. 5 derjenigen von Fig. 1. Die Flächenkondensatoren $F_1$, $F_2$ sind jedoch wie in Fig. 4 nicht direkt auf die Leiterführungsplatte 10 aufgebracht, sondern einseitig auf zwei übereinanderliegenden Folien 42, 44 aus Kunststoff in Form von Schlangenlinien. Die Folie 42, wie auch die entsprechend ausgebildete, nur teilweise sichtbare Folie 44, sind in einen nicht weiter dargestellten Schlitz zwischen dem Schenkel 12 und dem Verbindungssteg 14 gesteckt und erstrecken sich im wesentlichen über die ganze Oberfläche des Verbindungsstegs 16 und des Schenkels 14. Die Folien 42, 44 können auch bis in den Kontaktbereich einstückig ausgebildet sein und die Kontaktaugen 20 und Leiterbahnen 21 mitumfassen.

Die Flächenkondensatoren $F_1$, $F_2$ sind in an sich bekannter Weise auf die Folien 42, 44 abgeschieden, sie haben immer einen Abstand d von 0,1 bis 0,5 mm. Die Flächenkondensatoren $F_1$, $F_2$ sind paarweise mit je einer auf der Leiterführungsplatte 10 aufgebrachten Leiterbahn 21 verbunden.

Die untere Folie 44 ist wie erwähnt lediglich angedeutet, die schlangenlinenförmigen Flächenkondensatoren $F_1$, $F_2$ und die Anschlüsse an die Leiterbahnen 21 entsprechen denjenigen von Folie 42. Die Wirkung der Flächenkondensatoren $F_1$, $F_2$ entspricht derjenigen von Fig. 1. Selbstverständlich kann ein entsprechendes Dielektrikum 46 (Fig. 4) beidseits schlangenlinienförmige Flächenkondensatoren $F_1$, $F_2$ haben.

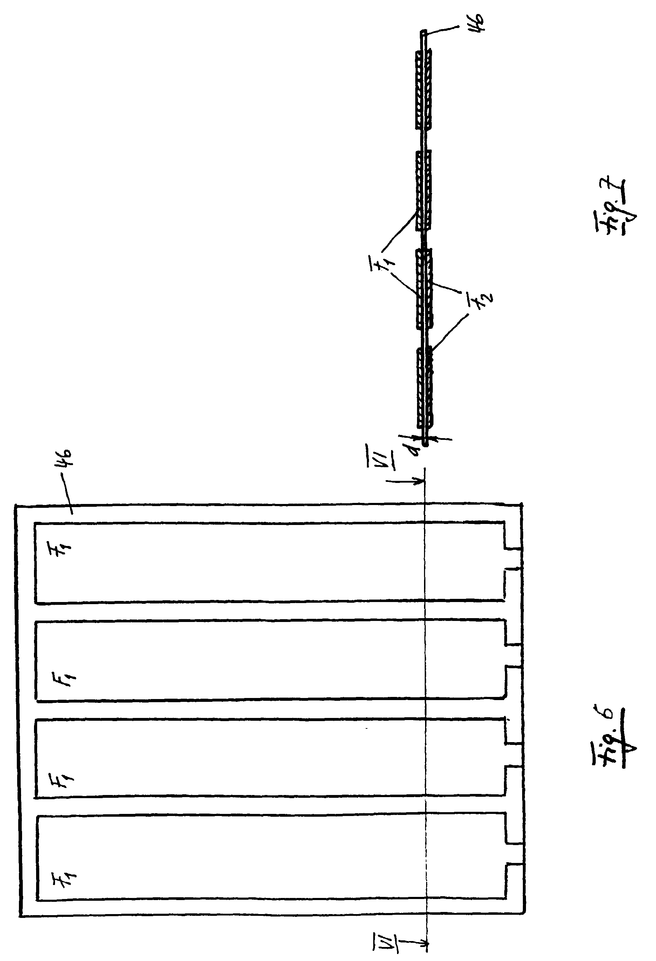

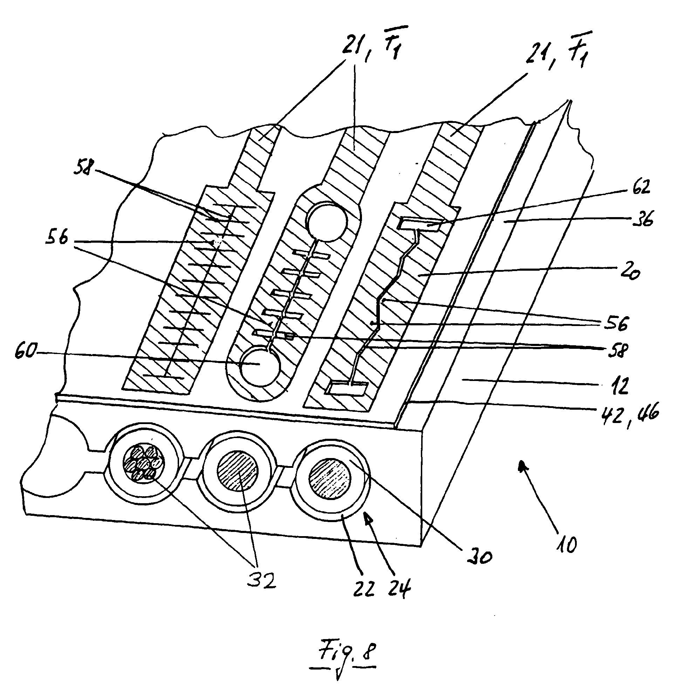

Fig. 6, 7 zeigen ein beidseits mit deckungsgleichen Flächenkondensatoren $F_1$, $F_2$ bestücktes, folienförmiges Dielektrikum 46. Die Ausführungsform gemäss Fig. 6, 7 gewährleistet eine grosse Kapazität, weil die Flächenkondensatoren $F_1$, $F_2$ vollflächig und in einem geringen Abstand d von weit weniger als 1 mm deckungsgleich aufeinander liegen. Mit entsprechender Materialwahl für das elektrisch isolierende Dielektrikum 46 kann die Kapazität noch vergrössert werden.

In Fig. 6 unten sind die Anschlüsse zu den Leiterbahnen 21 (Fig. 1) gezeigt.

Zweckmässig ist das beidseitig beschichtete Dielektrikum 46 gemäss Fig. 6, 7 jeweils vollflächig mit einer nicht dargestellten Schutzfolie abgedeckt, welche auch eine Isolationswirkung entfaltet, wenn mehrere beidseitig bestückte Folien aufeinander gelegt werden. Andernfalls ist eine Schutzfolie dazwischen zu legen.

In Fig. 8 ist der im Schenkel 12 angeordnete Kontaktbereich einer Leiterführungsplatte 10 dargestellt. Kontakschlitze 18 für elektrische Steckerkontakte 28 (Fig. 2) führen zu parallel im Schenkel 12 ausgesparten Bohrungen 22 mit eingezogenen Einzelleitern 24 mit Litzen oder Drähten 32. Die Kontaktschlitze 18 sind mit dem endständigen Teil der metallischen Leiterbahnen 21 abgedeckt, welche in diesem Bereich vorgefertigte Schnitte oder Stanzlinien 58 haben, die beim Einstossen der elektrischen Kontakte 28 (Fig. 2) elastisch umgebogene Lappen 56 mehrere elektrische Kontakte 20 (Fig. 3) bilden.

Nach einer ersten Variante sind mit Elektroerosions- oder Lasertechnik schmale Schnitte 58 ausgebildet, ein mittiger Längsschnitt und in regelmässigen Abständen Querschnitte. Nach einer zweiten Variante sind in ähnlicher fensterladenartigen Form breitere Stanzlinien 58 ausgebildet, mit die mittige Längslinie abschliessenden kreisrunden Stanzlöchern 60. Nach einer dritten Variante ist eine im mittleren Bereich der Leiterbahn 21 in unregelmässigem Zickzack längslaufende Stanzlinie 58 ausgebildet, welche beidends in einem rechteckigen Stanzloch 62 endet. Diese Stanzlinie 58 kann jedoch auch als regelmässige Sägezahnlinie mit zahlreichen Spitzen ausgebildet sein.

Alle in Fig. 8 gezeigten und ähnliche Varianten erlauben zahlreiche elektrische Kontaktstellen 20 (Fig. 3), welche dank der Elastizität der metallischen Lappen 56 dauernd auf den irreversibel eingestossenen elektrischen Kontakt 28 drükken und so einen niedrigen Übergangwiderstand gewährleisten.

**Patentansprüche**

1. Leiterführungsplatte (10) aus elektrisch isolierendem Material für die Einzelleiter (24) eines symmetrischen Kabels in einem mehrpoligen Stecker, insbesondere in einem HF-Stecker, welche integrierte oder eingeschobene Leiterführungsplatte (10) in die Bohrungen (22) für die Einzelleiter (24) mündende Kontaktschlitze (18) für die Führung elektrischer Steckerkontakte (28) aufweist,
dadurch gekennzeichnet, dass
die Leiterführungsplatte (10) in den Kontaktschlitzen (18) und um die Kontaktschlitze (18) herum ein elektrisch leitendes Kontaktauge (20) aufweist, welches beim Anpressen der Steckerkontakte (28) gleichzeitig mit den Einzelleitern (24) im Bereich der Leiterführungsplatte (10) angeordnete Kondensatoren zur Kompensation von Störeffekten anschliesst, wobei das Kontaktauge (20) direkt auf die Leiterführungsplatte (10) aufgebracht oder in Folienform eingelegt ist.

2. Leiterführungsplatte (10) nach Anspruch 1, dadurch gekennzeichnet, dass wenigstens ein Teil der Kontaktschlitze (18) elektrisch leitend mit Flächenkondensatoren ($F_1$, $F_2$) verbunden ist.

3. Leiterführungsplatte (10) nach Anspruch 1 oder 2, dadurch gekennzeichnet, dass sie aus isolierendem Kunststoff besteht und in der einschiebbaren Variante unter Ausbildung von zwei parallel versetzten Schenkeln (12, 14) mit Verbindungssteg (16) doppelt abgewinkelt oder abgerundet ist, also im Längsschnitt im wesentlichen Z-förmige Gestalt hat.

4. Leiterführungsplatte (10) nach einem der Ansprüche 1 bis 3, dadurch gekennzeichnet, dass die Kontaktaugen (20) mit Flächenkondensatoren ($F_1$, $F_2$) verbunden sind, auch über Leiterbahnen (21).

5. Leiterführungsplatte (10) nach einem der Ansprüche 1 bis 3, dadurch gekennzeichnet, dass die Flächenkondensatoren ($F_1$, $F_2$) beidseits eines an der Leiterführungsplatte (10) angebrachten folienförmigen Dielektrikums (46) der Dicke (d) einander gegenüberliegend ausgebildet sind.

**6.** Leiterführungsplatte (10) nach einem der Ansprüche 1 bis 4, dadurch gekennzeichnet, dass die Flächenkondensatoren ($F_1$, $F_2$) von zwei Kontaktaugen (20) in kleinem Abstand (d) auf derselben Ebene aneinander liegend gestaltet sind, vorzugsweise unter Bildung von möglichst langen seitlichen Grenzflächen der Flächenkondensatoren ($F_1$, $F_2$).

**7.** Leiterführungsplatte (10) nach Anspruch 5 oder 6, dadurch gekennzeichnet, dass die Flächenkondensatoren ($F_1$, $F_2$) durch Herausätzen aus einer vollen Fläche hergestellt oder durch ein Aditivverfahren auf die Folie aufgebracht sind.

**8.** Leiterführungsplatte (10) nach einem der Ansprüche 5 bis 7, dadurch gekennzeichnet, dass die Flächenkondensatoren ($F_1$, $F_2$) quadratisch, rechteckig, schlangenlinienförmig aneinander liegend, oder verästelt ineinander greifend ausgebildet sind.

**9.** Leiterführungsplatte (10) nach einem der Ansprüche 1 bis 8, dadurch gekennzeichnet, dass die Flächenkondensatoren ($F_1$, $F_2$) direkt auf der Leiterführungsplatte (10), bei im wesentlichen Z-förmiger Leiterführungsplatte (10) vorzugsweise auf dem Verbindungssteg (16), oder auf einer wenigstens im Kontaktbereich an der Leiterführungsplatte (10) angebrachten Kunststofffolie (42, 44) ausgebildet sind.

**10.** Leiterführungsplatte (10) nach einem der Ansprüche 1 bis 9, dadurch gekennzeichnet, dass die über den Kontaktschlitzen (18) liegenden endständigen Teile der zu den Flächenkondensatoren ($F_1$,$F_2$) führenden Leiterbahnen (21) vorgefertigte Schnitte oder Stanzlinien (58) haben, welche beim Einstossen eines elektrischen Kontakts (28) federnd umlegbare Lappen (56) bilden.

**11.** Leiterführungsplatte (10) nach Anspruch 10, dadurch gekennzeichnet, dass die Schnitte oder Stanzlinien (58) längsmittig und in Abstand beidseits quer, sägezahnförmig oder in unregelmässiger Zickzacklinie im Bereich der Längsmitte verlaufen.

**12.** Leiterführungsplatte (10) nach einem der Ansprüche 1 bis 11, dadurch gekennzeichnet, dass die Flächenkondensatoren ($F_1$, $F_2$), die Leiterbahnen (21) und die Kontaktaugen (20) aus einem Metall, vorzugsweise Kupfer oder Aluminium, und/oder einem metallpulverhaltigen Lack, und/oder einem metallpulverhaltigen, mit Metall beschichteten Lack bestehen.

Fig.1

Fig. 2

Fig. 3

Fig. 4

Fig. 2

Fig. 7

Fig. 6

*Fig. 8*

**Europäisches Patentamt**

# EUROPÄISCHER RECHERCHENBERICHT

Nummer der Anmeldung

EP 00 81 1196

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 5 967 801 A (KUVSHINIKOV TODD JASON ET AL) 19. Oktober 1999 (1999-10-19) * Spalte 3, Absätze 25-34; Abbildung 1 * --- | 1 | H01R13/66 H01R24/04 H01R13/719 |
| A | EP 0 649 194 A (THOMAS & BETTS CORP) 19. April 1995 (1995-04-19) * das ganze Dokument * --- | 1 | |
| A | WO 97 19499 A (SOES LUCAS ;SANDT JOHANNES LAMBERTUS VAN D (NL); WHITAKER CORP (US) 29. Mai 1997 (1997-05-29) * das ganze Dokument * ----- | 1 | |
| | | | **RECHERCHIERTE SACHGEBIETE (Int.Cl.7)** H01R |

Der vorliegende Recherchenbericht wurde für alle Patentansprüche erstellt

| Recherchenort | Abschlußdatum der Recherche | Prüfer |
|---|---|---|
| DEN HAAG | 6. März 2001 | Corrales, D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**   EP 00 81 1196

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-03-2001

| Im Recherchenbericht angeführtes Patentdokument | | Datum der Veröffentlichung | Mitglied(er) der Patentfamilie | | Datum der Veröffentlichung |
|---|---|---|---|---|---|
| US 5967801 | A | 19-10-1999 | DE | 19853666 A | 27-05-1999 |
| | | | FR | 2771554 A | 28-05-1999 |
| | | | GB | 2331873 A | 02-06-1999 |
| | | | JP | 11224741 A | 17-08-1999 |
| | | | US | 6113400 A | 05-09-2000 |
| EP 0649194 | A | 19-04-1995 | US | 5470244 A | 28-11-1995 |
| | | | CA | 2133635 A | 06-04-1995 |
| | | | DE | 69418966 D | 15-07-1999 |
| | | | DE | 69418966 T | 21-10-1999 |
| | | | EP | 0898340 A | 24-02-1999 |
| | | | ES | 2136170 T | 16-11-1999 |
| | | | JP | 3024050 B | 21-03-2000 |
| | | | JP | 7201394 A | 04-08-1995 |
| | | | JP | 2000100512 A | 07-04-2000 |
| | | | SG | 48308 A | 17-04-1998 |
| | | | US | 5454738 A | 03-10-1995 |
| WO 9719499 | A | 29-05-1997 | KEINE | | |

EPO FORM P0461

Für nähere Einzelheiten zu diesem Anhang : siehe Amtsblatt des Europäischen Patentamts, Nr.12/82